# EUROPEAN PATENT APPLICATION

(11) **EP 3 082 168 A1**
(43) Date of publication of application: **19.10.2016**
(21) Application number: 14869846.7
(22) Date of filing: 02.12.2014
(51) Int. Cl.: H01L 29/739, H01L 21/265, H01L 21/336, H01L 29/12, H01L 29/78

(54) **INSULATED GATE BIPOLAR TRANSISTOR AND PRODUCTION METHOD THEREFOR**

(30) Priority: 10.12.2013 JP 2013254850
(71) Applicant: ULVAC, Inc., Chigasaki-shi, Kanagawa 253-8543 (JP)
(72) Inventor: TONARI, Kazuhiko, Chigasaki-shi Kanagawa 253-8543 (JP); NAKAGAWA, Akio, Chigasaki-shi Kanagawa 253-8543 (JP); YOKOO, Hidekazu, Chigasaki-shi Kanagawa 253-8543 (JP); SUZUKI, Hideo, Chigasaki-shi Kanagawa 253-8543 (JP)
(74) Representative: Markfort, Iris-Anne Lucie
(86) International application number: PCT/JP2014/006010
(87) International publication number: WO 2015/087507

(57) **Abstract**

[Object] To provide a production method for insulated gate bipolar transistors, whereby the miniaturization or quality of a device can be improved.

[Solving Means] One embodiment of the present invention includes preparing a first conductive semiconductor substrate manufactured using the MCZ method. A second conductive base layer (12), first conductive emitter regions (13), and gate electrodes (14) are formed on a first surface of the semiconductor substrate. The semiconductor substrate is thinned by machining the second surface of the semiconductor substrate and a second conductive collector layer (15) is formed by implanting boron into the thinned second surface. A first conductive buffer layer (16) having a higher impurities concentration than the semiconductor substrate is formed by implanting hydrogen into an area inside the semiconductor substrate and adjacent to the collector layer (15).

## Description

### Technical Field

The present invention relates to an insulated gate bipolar transistor having an FS structure, and a method of producing the same.

### Background Art

As power devices for power conversion, an insulated gate bipolar transistor (IGBT) is known. The IGBT is a semiconductor apparatus for the purpose of decreasing a turn-on voltage (or turn-on resistance) of a high voltage power MOSFET (Metal-Oxide Semiconductor Field-Effect Transistor). A punch-through type IGBT (PT-IGBT), a non-punch-through type IGBT (NPT-IGBT), a field-stop type IGBT (FS-IGBT) or the like is developed.

The PT-IGBT decreases the turn-on voltage by implanting carriers at high concentration from a collector side. For the purpose of accelerating recombination of the carriers upon turning off, a life time control technology is applied, thereby decreasing a turn-off power loss. However, the effect of the life time control is undesirably reduced at high temperature environment, and the turn-off power loss is undesirably increased.

In the case of the NPT-IGBT, a low turn-on voltage and a low turn-off power loss are realized by thinning a thickness of a wafer to increase a carrier transport efficiency and by controlling an impurity concentration of a collector (p⁺ layer) to suppress a carrier implantation efficiency. However, as an n-drift layer needs to be thick so that a depletion layer does not reach to the collector side upon the turn-off, decreasing the turn-on voltage is limited.

On the other hand, in the case of the FS-IGBT, as the FS layer is formed for stopping the depletion layer, a thickness of the drift layer can be thinner than that in the NPT type, thereby further decreasing the turn-on voltage. Also, as the thickness of the drift layer is thin, there are less excess carriers. Accordingly, the turn-off power loss may be desirably decreased.

In the meantime, for manufacturing the IGBT device, an epitaxial substrate is widely used. However, in the production method using the epitaxial substrate, the manufacturing cost of devices is high, and crystal defects easily affect thereon. On the other hand, there is a known method of producing the IGBT using a silicon substrate manufactured by an FZ (Float Zone) method in place of the epitaxial substrate (for example, see Patent Document 1).

Patent Document 1: Japanese Unexamined Patent Application Publication (Translation of PCT Application) No. 2003-533047

### Disclosure of the Invention

### Problem to be solved by the Invention

However, in the case of the FZ method, there is a problem that a silicon substrate having a size of eight inches or more cannot be produced. Accordingly, there are various limitations attributed to a substrate size. For example, as a desired microfabrication technique is inapplicable, it is difficult to further miniaturize an IGBT device or to provide an IGBT device with a high quality.

In view of the circumstances as described above, it is an object of the present invention to provide an insulated gate bipolar transistor that can realize further miniaturization of a device or achieve a high quality device, and a method of producing the same.

### Means for solving the Problem

In order to achieve the above object, according to an embodiment of the present invention, there is provided a method of producing an insulated gate bipolar transistor including preparing a first conductive type semiconductor substrate manufactured by an MCZ method.

A second conductive type base layer is formed on a first surface of the semiconductor substrate.

A first conductive type emitter region is formed on a surface of the base layer.

A gate electrode that is insulated from the emitter region, the base layer and the semiconductor substrate is formed on the first surface.

The semiconductor substrate is thinned by machining the second surface of the semiconductor substrate.

A second conductive type collector layer is formed by implanting boron into the thinned second surface of the semiconductor substrate.

A first conductive type buffer layer having a higher impurity concentration than the semiconductor substrate is formed by implanting hydrogen into an area inside the semiconductor substrate and adjacent to the collector layer.

An insulated gate bipolar transistor according to an embodiment of the present invention includes a semiconductor layer, a base layer, an emitter region, a gate electrode, a collector layer, and a buffer layer.

The semiconductor layer is composed of a first conductive type MCZ substrate.

The base layer is formed on the semiconductor layer, and is composed of a second conductive type semiconductor.

The emitter region is formed on a surface of the base layer, and is composed of a first conductive type semiconductor.

The gate electrode is formed by insulating from the emitter region, the base layer and the semiconductor layer.

The collector layer is formed at a surface opposite to a surface of the semiconductor layer on which the base layer is formed, and is composed of a second conductive type semiconductor.

The buffer layer is formed at an interface between the semiconductor layer and the collector layer, and is composed of a first conductive type semiconductor having a higher impurity concentration than the semiconductor layer.

### Brief Description of Drawings

[Fig. 1] A schematic cross-sectional view showing an insulated gate bipolar transistor according to an embodiment of the present invention.
[Fig. 2] A schematic cross-sectional view illustrating a method of producing the insulated gate bipolar transistor, and showing a step of forming a surface electrode.
[Fig. 3] A schematic cross-sectional view illustrating a method of producing the insulated gate bipolar transistor, and showing a step of forming a surface electrode.
[Fig. 4] A schematic cross-sectional view illustrating a method of producing the insulated gate bipolar transistor, and showing a step of thinning a wafer.
[Fig. 5] A schematic cross-sectional view illustrating a method of producing the insulated gate bipolar transistor, and showing a step of forming a collector layer.
[Fig. 6] A schematic cross-sectional view illustrating a method of producing the insulated gate bipolar transistor, and showing a step of forming a collector layer.
[Fig. 7] A schematic cross-sectional view illustrating a method of producing the insulated gate bipolar transistor, and showing a step of forming a buffer layer.
[Fig. 8] A schematic cross-sectional view illustrating a method of producing the insulated gate bipolar transistor, and showing a step of forming a buffer layer.
[Fig. 9] A schematic cross-sectional view illustrating a method of producing the insulated gate bipolar transistor, and showing a step of forming a rear surface electrode.

### Best Modes for Carrying Out the Invention

A method of producing an insulated gate bipolar transistor according to an embodiment of the present invention includes preparing a first conductive type semiconductor substrate manufactured by an MCZ method.

A second conductive type base layer is formed on a first surface of the semiconductor substrate.

A first conductive type emitter region is formed on a surface of the base layer.

A gate electrode that is insulated from the emitter region, the base layer and the semiconductor substrate is formed on the first surface.

The semiconductor substrate is thinned by machining the second surface of the semiconductor substrate.

A second conductive type collector layer is formed by implanting boron into the thinned second surface of the semiconductor substrate.

A first conductive type buffer layer having a higher impurity concentration than the semiconductor substrate is formed by implanting hydrogen into an area inside the semiconductor substrate and adjacent to the collector layer.

In the production method, the MCZ substrate is used as the semiconductor substrate. The MCZ substrate is a silicon substrate manufactured by an MCZ (magnetic field applied CZ) method. The MCZ method is a kind of a Czochraski (CZ) method where a magnetic field is applied to a melt to grow single crystal. By the MCZ method, a substrate having a size of 8 inches (diameter of about 200 mm) or more can be easily produced. For example, a large diameter substrate having a size of 12 inches (diameter of about 300 mm) is relatively easily available. This allows a variety of microfabrication techniques applied to the large diameter substrate to be used. The IGBT device can be further miniaturized or can have a high quality (high performance), and the productivity can be improved.

The magnetic field applied to the melt may be a static magnetic field, or a variable magnetic field. Examples of the static magnetic field include an HMCZ (horizontal MCZ), a VMCZ (vertical MCZ) and a Cusp MCZ, for example.

The step of forming the collector layer includes a first annealing process that heats the second surface at a first temperature (for example, 400°C or more, preferably 450°C or more) typically after the implantation of boron. In this case, the step of forming the buffer layer includes a second annealing process that heats the second surface at a second temperature (for example, from 250°C or more to 500°C or less) typically after the implantation of hydrogen.

By carrying out the annealing process after the implantation of boron separately from the annealing process after the implantation of hydrogen, the diffusion and the activation of boron implanted and the stabilization of the donor formed by the hydrogen implantation can be carried out properly, respectively.

The buffer layer may be formed after the first annealing process.

Typically, the temperature needed for the diffusion and the activation of boron is higher than the temperature needed for the diffusion of hydrogen. Accordingly, by forming the buffer layer after the first annealing process and carrying out the second annealing process at a second temperature (for example, from 280°C or more to 450°C or less) lower than the first temperature, it is possible to diffuse implanted hydrogen adequately. In this manner, the buffer layer having a desired field-stop function can be formed.

The first annealing process and the second annealing process may be carried out by using a heating furnace. This allows process costs to be reduced.

The gate electrode may be formed before the semiconductor substrate is thinned.

In this manner, a handling property of the substrate can be held in the steps of forming the base layer, the emitter region, the gate electrode, etc.

An insulated gate bipolar transistor according to an embodiment of the present invention includes a semiconductor layer, a base layer, an emitter region, a gate electrode, a collector layer, and a buffer layer.

The semiconductor layer is composed of a first conductive type MCZ substrate.

The base layer is formed on the semiconductor layer, and is composed of a second conductive type semiconductor.

The emitter region is formed on a surface of the base layer, and is composed of a first conductive type semiconductor.

The gate electrode is formed by insulating from the emitter region, the base layer and the semiconductor layer.

The collector layer is formed at a surface opposite to a surface of the semiconductor layer on which the base layer is formed, and is composed of a second conductive type semiconductor.

The buffer layer is formed at an interface between the semiconductor layer and the collector layer, and is composed of a first conductive type semiconductor having a higher impurity concentration than the semiconductor layer.

According to the IGBT of the embodiment, as the MCZ substrate is used as the semiconductor layer, a substrate having a size of 8 inches (diameter of about 200 mm) or more can be easily produced. For example, a large diameter substrate having a size of 12 inches (diameter of about 300 mm) is relatively easily available. This allows a variety of microfabrication techniques applied to the large diameter substrate to be used. The IGBT device can be further miniaturized or can have a high quality (high performance), and the productivity can be improved.

Hereinafter, embodiments according to the present invention will be described with reference to the drawings.

### [Structure of IGBT]

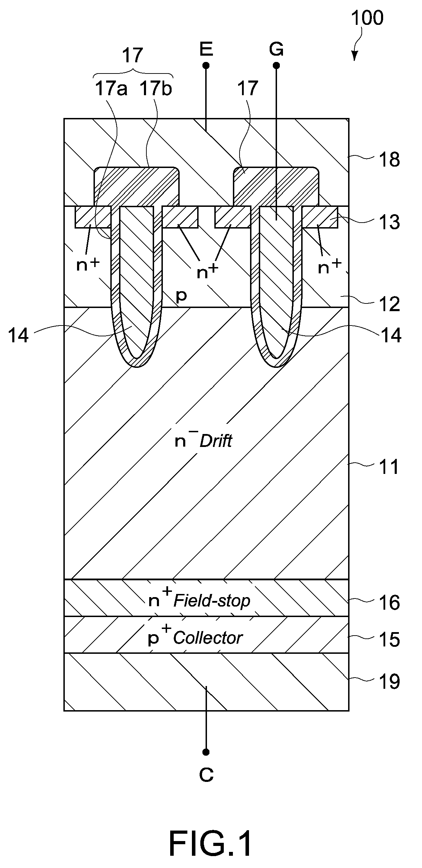

Fig. 1 is a schematic cross-sectional view showing an insulated gate bipolar transistor according to an embodiment of the present invention. In the embodiment, an n channel vertical IGBT is taken as an example. The embodiment is preferably applied to that having a voltage rating of 600 to 1200 V, but it is not limited thereto.

An insulated gate bipolar transistor (hereinafter referred to as "IGBT") 100 according to the embodiment includes a drift layer 11 (semiconductor layer), a base layer 12, emitter regions 13, gate electrodes 14, a collector layer 15, a buffer layer 16, an emitter electrode 18 and a collector electrode 19.

The drift layer 11 is composed of an n⁻ type (first conductive type) semiconductor having a relatively high resistance that supports a voltage between a collector (C) and an emitter (E). The drift layer 11 is composed of an n⁻ type silicon single crystal substrate manufactured by an MCZ method (hereinafter simply referred to as "MCZ substrate"). A thickness of the drift layer 11 is about 50 to 300 µm, for example, and an impurity concentration of the drift layer 11 is 1 x 10¹² to 1 x 10¹⁵ cm⁻³, for example.

The base layer 12 is formed on (one surface of) the drift layer 11, and is composed of a p-type (second conductive type) semiconductor. By implanting boron as the impurity element on the surface of the drift layer 11, the base layer 12 is formed by diffusion, for example. A thickness of the base layer 12 is about 1 to 5 µm, for example, and an impurity concentration of the base layer 12 is 1 x 10¹⁷ to 1 x 10¹⁸ cm⁻³, for example.

A plurality of the emitter regions 13 are formed on the surface of the base layer 12, and are composed of an n⁺ type semiconductor having an impurity concentration higher than that of the drift layer 11. The emitter regions 13 are formed in a plurality of lattices extending to a vertical direction on the sheet of paper, for example. The emitter regions 13 are formed by implanting phosphorus as the impurity element on the surface of the base layer 12, for example. A thickness of each emitter region 13 is 0.5 to 2 µm, for example, and an impurity concentration of each emitter region 13 is 1 x 10¹² to 1 x 10²¹ cm⁻³, for example.

The gate electrodes 14 are formed on the other surface of the drift layer 11 and are insulated from the emitter regions 13, the base layer 12 and the drift layer 11. The IGBT 100 has a trench gate structure, the gate electrodes 14 are penetrated through the base layer 12 in a thickness direction, and are formed in a lattice in the vertical direction on the sheet of paper between the predetermined emitter regions adjacent each other, for example.

The gate electrodes 14 are typically composed of polysilicon, but may be composed of others such as a metal material. The gate electrodes 14 are electrically insulated from the emitter regions 13, the base layer 12 and the drift layer 11 by gate oxides 17.

Each gate oxide 17 is composed of silicon oxide, for example, and includes a first gate oxide film 17a and a second gate oxide film 17b. The first gate oxide film 17a and the second gate oxide film 17b are integrally connected each other. The first gate oxide film 17a is formed at an interface between the gate electrode 14 and the emitter region 13 and between the base layer 12 and the drift layer 11. The second gate oxide film 17b is formed at an interface between the gate electrode 14 and the emitter electrode 18.

The collector layer 15 is formed at an opposite surface (rear surface) of the drift layer 11 to the surface on which the base layer 12 is formed, and is composed of p⁺ type semiconductor having an impurity concentration higher than the base layer. The collector layer 15 is formed by implanting boron as an impurity element on the rear surface of the drift layer 11, for example. A thickness of the collector layer 15 is 0.1 to 1 µm, for example, and an impurity concentration of the collector layer 15 is 1 x 10¹⁶ to 1 x 10¹⁸ cm⁻³, for example.

The buffer layer 16 is formed at an interface between the drift layer 11 and the collector layer 15, and is composed of n⁺ type semiconductor having an impurity concentration higher than the drift layer 11. The buffer layer 16 functions as a field-stop (FS) layer that prevents a depletion layer formed in the base layer 12 when a voltage is applied between the gate (G) and the emitter (E) from reaching.

The buffer layer 16 is formed by implanting hydrogen as an impurity element on the rear surface of the drift layer 11. A thickness of the buffer layer 16 is 1 to 20 µm, for example, and an impurity concentration of the buffer layer 16 is 1 x 10¹⁵ to 1 x 10¹⁸ cm⁻³, for example.

The emitter electrode 18 is formed on the surface of the base layer 12, and is composed of a metal material such as aluminum, for example. The emitter electrode 18 is electrically connected to the base layer 12 and the emitter regions 13, and is electrically insulated from the gate electrodes 14 via the gate oxides 17.

The collector electrode 19 is composed of a metal film formed on the surface of the collector layer 15. The collector electrode 19 may be a metal single layer, or may be a multiple layer of dissimilar metals. In the embodiment, the collector electrode 19 is composed of a laminated film of aluminum (Al), chromium (Cr), nickel (Ni) and gold (Au).

### [Method of producing IGBT]

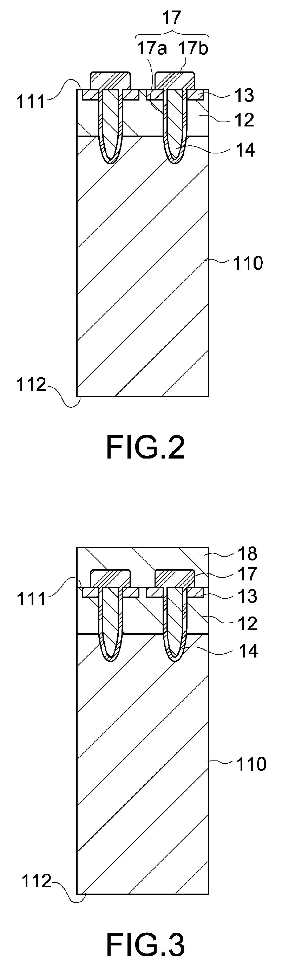

Next, a method of producing the IGBT 100 configured as described above will be described. Fig. 2 to Fig. 9 are schematic cross-sectional views of each step illustrating the method of producing the IGBT 100.

### (Step of forming surface electrode)

As shown in Fig. 2, an n⁻ type semiconductor substrate (silicon substrate) 110 manufactured by an MCZ method is prepared. A diameter of the semiconductor substrate 110 is eight inches or more. In the embodiment, a 12-inch wafer is used. A thickness of the semiconductor substrate 110 is not especially limited, and is 600 to 1200 µm, for example.

Next, on a surface 111 (first surface) of the semiconductor substrate 110, the base layer 12, the emitter regions 13, and the gate electrodes 14 are formed (Fig. 2).

The base layer 12 is formed by implanting a predetermined dose amount (for example, 1 x 10¹³ to 1 x 10¹⁴ ion/cm²) of a p-type impurity such as boron on the surface 111 of the semiconductor substrate 110, and then thermally diffusing the implanted p-type impurity. The emitter regions 13 are formed by implanting a predetermined dose amount (for example, 5 x 10¹⁴ to 1 x 10¹⁶ ion/cm²) of an n-type impurity such as phosphorus on predetermined regions on the surface of the base layer 12, and then diffusing the implanted n-type impurity. For the formation of the base layer 12 and the emitter regions 13, a beam line type ion implantation apparatus, a plasma doping apparatus, or the like is used.

A method of forming the gate electrodes 14 includes a step of forming trenches on the surface 111 of the semiconductor substrate 110, a step of coating inner wall surfaces of the trenches with first gate oxide films 17a, and a step of filling insides of the trenches with polysilicon over the first gate oxide films 17a. Thereafter, the gate electrodes 14 and portions of the emitter regions 13 therearound are coated with the second gate oxide films 17b, thereby forming wiring for externally drawing the gate electrodes 14.

Subsequently, as shown in Fig. 3, the emitter electrode 18 is formed on the surface 111 of the semiconductor substrate 110. In the embodiment, an aluminum film is formed by sputtering, which is patterned in a predetermined shape, thereby forming the emitter electrode 18.

### (Thinning step)

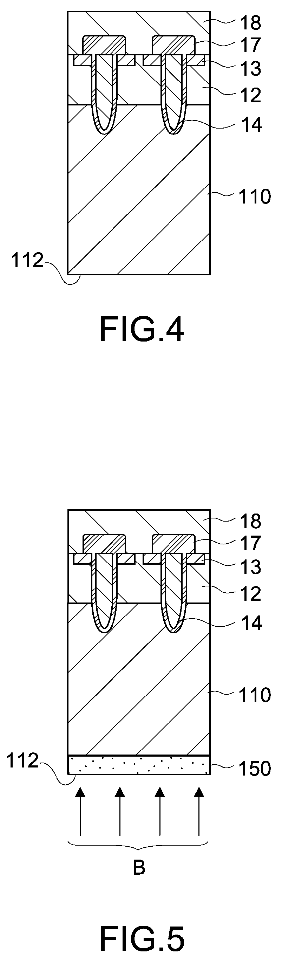

Next, as shown in Fig. 4, the rear surface 112 (second surface) of the semiconductor substrate 110 is processed to thin the semiconductor substrate 110. By carrying out the thinning step after the surface 111 of the semiconductor substrate 110 is processed, a handling property of the substrate can be held in the steps of forming the base layer 12, the emitter regions 13, the gate electrodes 14, the emitter electrode 18, etc.

In the thinning step, the semiconductor substrate 110 is thinned to a thickness of 60 to 130 µm, for example. To the thinning step, a machine polishing method using a grinder or a polishing cloth, a CMP (Chemical-Mechanical Polishing) method where machine polishing is combined with a chemical polishing, a plasma treatment method such as etch back or the like is applicable.

### (Step of forming collector layer and buffer layer)

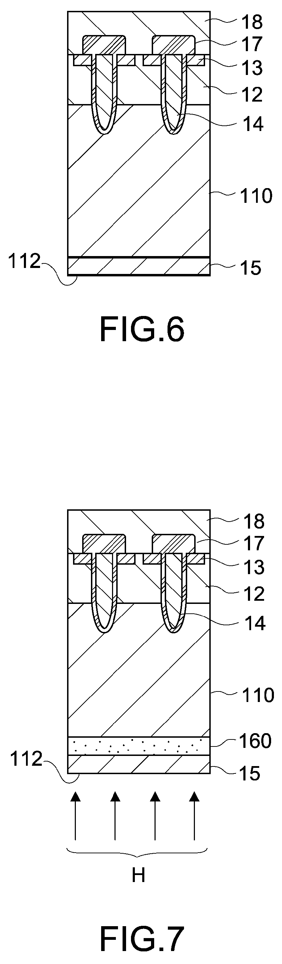

Subsequently, as shown in Fig. 5 and Fig. 6, on the rear surface 112 of the semiconductor substrate 110, the collector layer 15 is formed.

In the step of forming the collector layer 15, a predetermined dose amount (for example, 1 x 10¹² to 1 x 10¹⁴ ion/cm²) of boron is firstly implanted with predetermined energy (for example, 10 to 100 keV). Next, a first annealing process is carried out to heat the rear surface 112 of the semiconductor substrate 110 to a predetermined temperature, thereby diffusing and activating boron implanted into a dose region 150 while relaxing an internal stress of the dose region 150. In this manner, the p⁺ type collector layer 15 having a predetermined concentration is formed (Fig. 6).

A method of heating in the first anneal process is not especially limited. In the embodiment, a furnace anneal method using a heating furnace is employed. This allows process costs to be reduced.

An anneal temperature (first temperature) in the first anneal process is set to a temperature that can sufficiently diffuse and activate boron and has no effect on the emitter electrode 18, e.g., at 400°C or more to 550°C or less. In this manner, the collector layer 15 having the desired conductivity characteristics can be formed without affecting a surface electrode of the semiconductor substrate 110.

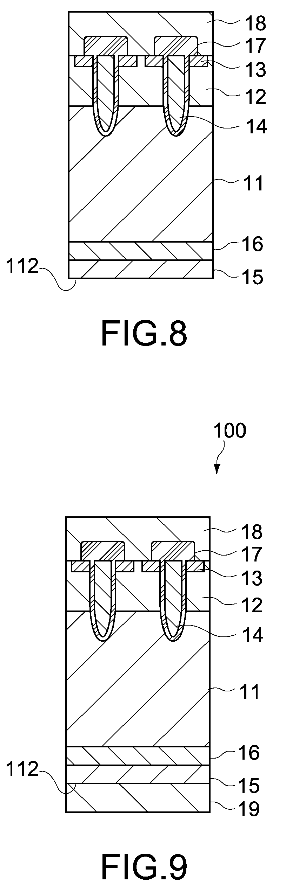

Subsequently, as shown in Fig. 7 and Fig. 8, the buffer layer 16 is formed inside the semiconductor substrate 110 and adjacent to the collector layer 15.

In the step of forming the buffer layer 16, a predetermined dose amount (for example, 1 x 10¹⁴ to 1 x 10¹⁶ ion/cm²) of hydrogen is firstly implanted with predetermined energy (for example, 200 to 1000 keV) to the rear surface 112 of the semiconductor substrate 110. The hydrogen has smallest atomic radius, and therefore easily passes through the collector layer 15. In this manner, a dose region 160 having a predetermined thickness adjacent to the collector layer 15 can be formed.

Next, a second annealing process is carried out to heat the rear surface 112 of the semiconductor substrate 110 to a predetermined temperature, thereby stabilizing a donor formed at the dose region 160 while relaxing an internal stress of the dose region 160. In this manner, the n⁺ type buffer layer 16 having a predetermined concentration is formed (Fig. 8).

A method of heating in the second anneal process is not especially limited. In the embodiment, a furnace anneal method using a heating furnace is employed. This allows process costs to be reduced.

An anneal temperature (second temperature) in the second anneal process is not especially limited and set to from 250°C or more to 500°C or less. In the embodiment, the second temperature is set to a temperature where an effect of stabilizing the donor generated from crystal defects that are formed by hydrogen implantation, e.g., from 280°C or more to 450°C or less. In this manner, the buffer layer 16 having the desired conductivity characteristics can be formed.

By the formation of the buffer layer 16, the drift layer 11 is formed inside the semiconductor substrate 110, and is sandwiched between the base layer 12 and the buffer layer 16 (Fig. 8). The drift layer 11 is composed of an n⁻ type semiconductor layer that has the same conductivity type as the semiconductor substrate 110.

For the implantation of boron for forming the collector layer 15 and the implantation of hydrogen for forming the buffer layer 16, a beam line type ion implantation apparatus, a plasma doping apparatus, or the like is used.

### (Step of forming rear surface electrode)

After the formation of the buffer layer 16, as shown in Fig. 9, the collector electrode 19 is formed on the rear surface 112 of the semiconductor substrate 110. In the embodiment, an Al film a Cr film, a Ni film and an Au film are formed by a sputtering method in this order, thereby forming the collector electrode 19. Thereafter, the semiconductor substrate 110 is divided into pieces each having a predetermined device size, thereby producing the IGBT 100 according to the embodiment.

### [Operation of embodiment]

As described above, in the embodiment, as the MCZ substrate is used as the semiconductor substrate, a substrate having a size of 8 inches (diameter of about 200 mm) or more can be easily produced. For example, a large diameter substrate having a size of 12 inches (diameter of about 300 mm) is relatively easily available. This allows a variety of microfabrication techniques applied to the large diameter substrate to be used. The IGBT device can be further miniaturized or can have a high quality (high performance), and the productivity can be improved.

In addition, in the embodiment, since the first annealing process after the implantation of boron for forming the collector layer 15 is carried out separately from the second annealing process after the implantation of hydrogen for forming the buffer layer 16, the diffusion and the activation of boron implanted and the formation of the donor by hydrogen can be performed properly, respectively.

Furthermore, in the embodiment, the buffer layer 16 is formed after the formation of the collector layer 15. As described above, the temperature needed for the diffusion and the activation of boron is higher than the temperature needed for the stabilization of the donor by hydrogen. Accordingly, by forming the buffer layer 16 after the first annealing process, the donor can be processed adequately by hydrogen implanted. In this manner, the buffer layer having a desired field-stop function can be formed.

While the present invention is described herein with reference to illustrative embodiments, it should be understood that the invention is not limited thereto. It should be appreciated that variations and modifications may be made without departing from the spirit of the present invention.

For example, in the embodiment, although the n channel vertical IGBT is described as an example, but it is not limited thereto. The present invention is applicable to a p channel vertical IGBT.

Also, in the above-described embodiment, the IGBT having the trench gate structure is described as an example. Alternatively, the present invention is applicable to an IGBT having a planer gate structure.

Furthermore, in the embodiment, the furnace anneal method is employed for the annealing process (first annealing process) for the formation of the collector layer 15. Alternatively, other annealing methods such as laser annealing may be applicable.

Further, a heat treatment (sinter annealing) for sintering the emitter electrode 18 and the surface 111 of the semiconductor substrate 110 may be additionally carried out. In this case, since a sintering temperature should be higher than the temperature of the annealing process (second annealing process) for the formation of the buffer layer 16, the sintering process is preferably carried out before the formation of the buffer layer 15. Also, the sintering process may be carried out together with the annealing process (first annealing process) for the formation of the collector layer 15.

As phosphorus and boron are ion-implanted on the rear surface 112 of the semiconductor substrate 110, the sinter annealing is carried out after the formation of the buffer layer 16 and the collector layer 15 using phosphorus. Thus, the buffer layer 16 and the collector layer 15 can be annealed and formed at the same time. Thereafter, hydrogen is further implanted into the rear surface 112 of the semiconductor substrate, which is annealed. Thus, the donor formed by hydrogen may be combined with the donor formed by phosphorus to form the buffer layer 16. In this case, the buffer layer may be formed by overlapping the donor formed by hydrogen with the donor formed by phosphorus. The buffer layer may be formed sequentially adjacent to the donor by phosphorus on the semiconductor substrate 110 at a side nearer to the surface 111 than the donor by phosphorus. Alternatively, other buffer away therefrom may be formed.

As the donor by phosphorus has a property different from that of the donor by hydrogen, device properties can be improved. For example, the donor by phosphorus reduces an activation ratio and shortens a carrier lifetime.

Also, the hydrogen implantation and the annealing process may be carried out after the formation of the collector electrode. Alternatively, after the implantation of phosphorus and boron and the laser annealing, the implantation of hydrogen and the annealing process may be carried out. By sequentially carrying out a plurality of times the hydrogen implantation, it is possible to form the buffer layer in which the concentration of the donor is changed stepwise.

An oxygen concentration of the MCZ substrate used is preferably 1 x 10¹⁸/cm⁻³ or less, more preferably 5 x 10¹⁷/cm⁻³ or less in order to achieve excellent device properties.

According to the present invention, it is found that a fine alignment is possible by using an MCZ wafer having a large diameter than the FZ substrate in the related art, and the device properties can be improved.

- 11: drift layer
- 12: base layer
- 13: emitter region
- 14: gate electrode
- 15: collector layer
- 16: buffer layer
- 17: gate oxide
- 18: emitter electrode
- 19: collector electrode
- 100: IGBT (insulated gate bipolar transistor)
- 110: semiconductor substrate

## Claims

1. A method of producing an insulated gate bipolar transistor, comprising:
preparing a first conductive type semiconductor substrate manufactured by an MCZ method;
forming a second conductive type base layer on a first surface of the semiconductor substrate;
forming a first conductive type emitter region on a surface of the base layer;
forming a gate electrode that is insulated from the emitter region, the base layer and the semiconductor substrate on the first surface;
thinning the semiconductor substrate by machining the second surface of the semiconductor substrate;
forming a second conductive type collector layer by implanting boron into the thinned second surface of the semiconductor substrate; and
forming a first conductive type buffer layer having a higher impurity concentration than the semiconductor substrate by implanting hydrogen into an area inside the semiconductor substrate and adjacent to the collector layer.

2. The method of producing an insulated gate bipolar transistor according to claim 1, wherein
forming the collector layer includes a first annealing process to heat the second surface at a first temperature after the implantation of boron,
forming the buffer layer includes a second annealing process to heat the second surface at a second temperature after the implantation of hydrogen.

3. The method of producing an insulated gate bipolar transistor according to claim 2, wherein
the buffer layer is formed after the first annealing process.

4. The method of producing an insulated gate bipolar transistor according to claim 2 or 3, wherein
the first annealing process and the second annealing process are carried out by using a heating furnace.

5. The method of producing an insulated gate bipolar transistor according to any one of claims 2 to 4, wherein
the first temperature is 400°C or more, and
the second temperature is from 250°C or more to 500°C or less.

6. The method according to any one of claims 1 to 5, wherein
the gate electrode is formed before the semiconductor substrate is thinned.

7. The method according to any one of claims 1 to 6, wherein
the semiconductor substrate has a diameter of eight inches or more.

8. An insulated gate bipolar transistor, comprising:
a first conductive type semiconductor layer composed of an MCZ substrate;
a second conductive type base layer formed on the semiconductor layer;
a first conductive type emitter region formed on a surface of the base layer;
a gate electrode formed by insulating from the emitter region, the base layer and the semiconductor layer;
a second conductive type collector layer formed at a surface opposite to a surface of the semiconductor layer on which the base layer is formed; and
a first conductive type buffer layer formed at an interface between the semiconductor layer and the collector layer having a higher impurity concentration than the semiconductor layer.
